# EUROPEAN PATENT SPECIFICATION

(11) **EP 2 410 614 B1**
(45) Date of publication and mention of the grant of the patent: **10.02.2016**
(21) Application number: 11174763.0
(22) Date of filing: 20.07.2011
(51) Int. Cl.: H01R 4/24, H01R 12/51, H01R 12/57, H01R 13/11, H01R 43/02, H01R 43/16

(54) **Surface mount contact and connector using same**
Oberflächenmontagekontakt und Verbinder damit
Contact à montage en surface et connecteur l'utilisant

(30) Priority: 20.07.2010 JP 2010163287
(43) Date of publication of application: 25.01.2012
(73) Proprietor: Tyco Electronics Japan G.K., Takatsu-ku Kawasaki-shi Kagawa 213-8535 (JP)
(72) Inventor: Nagasaki, Taisuke, Kawasaki, Kanagawa 213-8535 (JP); Kato, Hirokazu, Kawasaki, Kanagawa 213-8535 (JP)
(74) Representative: Johnstone, Douglas Ian

(56) References cited:
- DE-A1-102004 049 575
- DE-A1-102005 050 796
- JP-A- 2010 514 138
- US-A1- 2006 189 174

## Description

The present invention relates to a surface mount contact mounted on substrates such as a substrate on which an LED module is mounted and a substrate made up of an LED package, and a connector using the contact.

Traditionally, an LED lighting equipment using an LED is known to the public. In the LED lighting equipment, for example, an LED module is mounted on a substrate and an LED package constituting a substrate in which an LED chip is enclosed is used. In the LED module and in the LED package, energization of the LED chip is compulsory. Conventionally, it is known technology, as disclosed in Patent Document 1, to connect, via a lead wire, between an input terminal of an LED mounted substrate and an output terminal of an AC-DC converter connected to a commercial power supply, for energizing the LED chip. In the technology disclosed in Patent Document 1, the lead wire is directly solder joined to the input terminal of the LED mounted substrate.

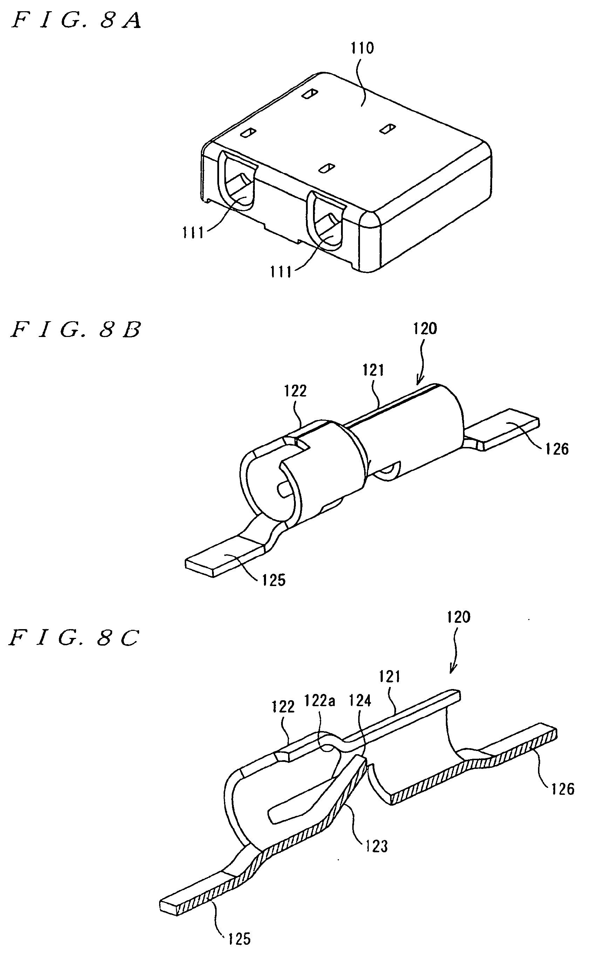

Patent Document 2 discloses an LED connector having a socket contact to elastically contact a terminal of an LED chip for energizing the LED chip. The socket contact having a wire connecting section where the socket contact connects an electric wire connected to a power supply. In the socket contact, the electrical wire is connected to the wire connecting section by crimping. Furthermore, Patent Document 3 discloses a low-profile surface mount poke-in connector to energize the LED chip which is shown in Fig 8.

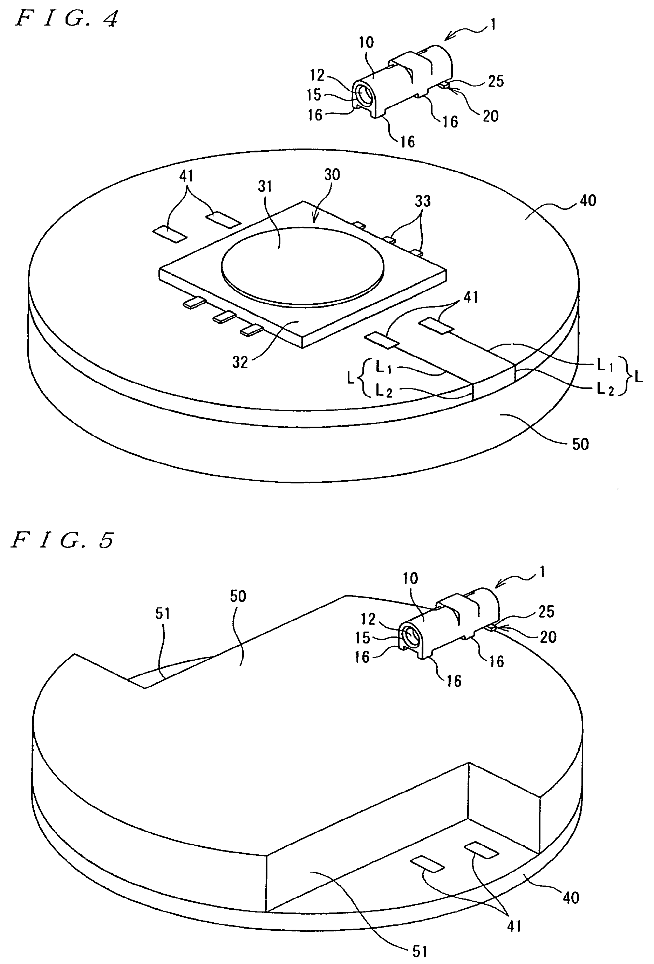

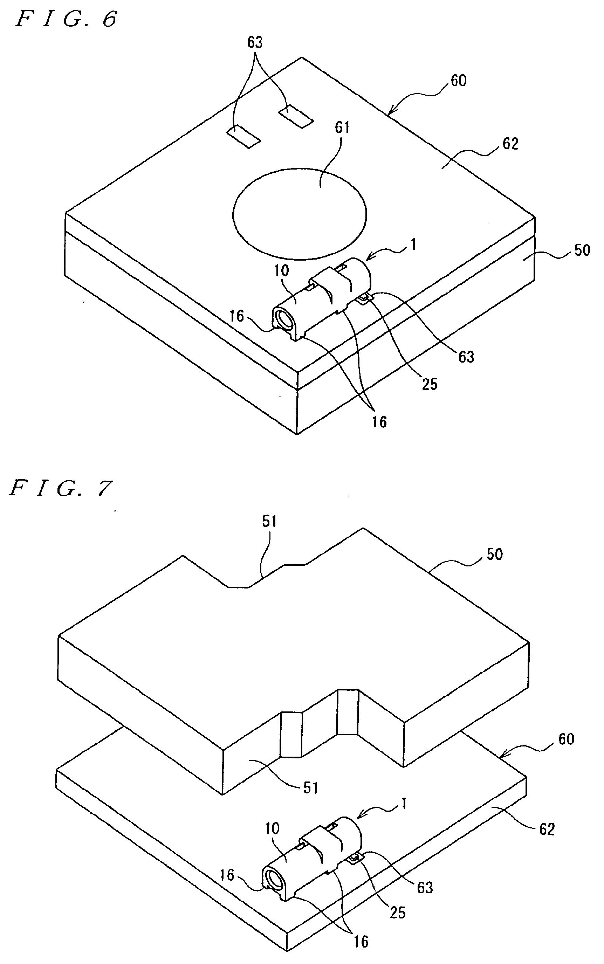

The poke-in connector shown in FIG. 8 is composed of an insulating housing 110 shown in FIG. 8A and two contacts 120 shown in FIG. 8B, which are accommodated in the housing 110. The poke-in connector is mounted, for example, on a substrate 40 on which an LED module is mounted (see FIG. 4), or on a substrate 62 made up of an LED package (see FIG. 6). The housing 110 is made by molding insulating resin, on the front (the left side in FIG. 8A) of which two openings 111 for inserting an electrical wire are formed. The electrical wire (not shown) is connected to a power supply.

Further, each contact 120 has a cylindrical small-diameter portion 121 and a cylindrical large-diameter portion 122 connected to the front end of the small-diameter portion 121 as shown in FIG. 8B. The each contact 120 is made by stamping and forming a metal plate. On a bottom wall of the large-diameter portion 122, a lance 123 is provided, which is cut and bent from the bottom wall toward the inside of the small-diameter portion 121 so as to extend diagonally. At the tip of the lance 123, a sharp edge 124 is formed. The electrical wire is inserted into the large-diameter portion 122 through the opening 111 of the housing 110 while being guided thereto. An end of a covering portion of the electrical wire abuts against a shoulder 122a formed in the large-diameter portion 122 to prevent further insertion of the electrical wire. Upon slight outward pulling of the electrical wire, the sharp edge 124 formed on the tip of the lance 123 bites into a core wire which projects from the front end of the covering portion of the electrical wire for connecting the electrical wire to the contact 120, and for preventing extraction of the electrical wire. Such, a contact, which can be connected to the electrical wire by merely inserting the electrical wire into the contact, is generally called as a poke-in contact.

Moreover, at the front end (the left side shown in FIG. 8B) of the large-diameter portion 122, a surface mount soldering portion 125 is provided. The surface mount soldering portion 125 extends forward along an axial direction of the contact 120 from the bottom of the front end of the large-diameter portion 122. At the rear end of the small-diameter portion 122, a surface mount soldering portion 126 is also provided. The surface mount soldering portion 126 extends backward along an axial direction of the contact 120 from the bottom of the rear end of the small-diameter portion 121. These surface mount soldering portions 125,126 are solder connected, for example, to the substrate 40 on which the LED module is mounted, or to a conductive pad formed on the substrate 62 made up of the LED package. The conductive pad is electrically connected to an electrode of the LED chip, which electrically connects the electrical wire with the electrode of the LED chip, enabling energization of the LED.

### Patent Documents

Patent Document 1: JP 2009-99627 A
Patent Document 2: JP 2006-114791 A
Patent Document 3: JP 2010-514138 A

These conventional prior art contacts, involve problems as will be shown below. Namely, in case of the technology disclosed in Patent Document 1, the lead wire is directly solder connected to the input terminal of the LED mounted substrate. Therefore, the technology necessitates doing work to connect the core wire of the electrical wire to the input terminal and a work to solder connect the core wire of the electrical wire carried on to the input terminal. This leads to very poor assembly working efficiency.

Further, in case of the technology disclosed in Patent Document 2, the electrical wire is connected to the electrical wire connecting section of the socket contact by crimping. Therefore, the technology compels doing work to connect the end of the electrical wire to the electrical wire connecting section of the socket contact and a work to crimp by means of a crimping tool the end of the electrical wire carried on to the electrical wire connecting section. This also leads to very poor assembly working efficiency.

In case of the low-profile surface mount poke-in connector disclosed in Patent Document 3 shown in FIG. 8, less work is involved in the connection of the electrical wire owing to the adoption of the poke-in contact, and assembly working efficiency may accordingly be improved. Nevertheless, in the low-profile surface mount poke-in connector disclosed in Patent Document 3, the large-diameter portion 122 for guiding the end of the covering portion of the electrical wire to the contact 120 is provided, and the large-diameter portion 122 is provided with the shoulder 122a to stop insertion of the end of the covering portion of the electrical wire into the small diameter portion 121. Accordingly, enlargement of the contact 120 occurs by the presence of the large-diameter portion 122. It follows, in addition thereto, that enlargement of the poke-in connector in which the contact 120 is accommodated occurs. Thus, the enlarged contact 120 and the poke-in connector give rise to a situation in which light emitted from the LED is blocked off by the connector, leading to degradation of, so-called, light distribution characteristics.

Moreover, in the case of the low-profile surface mount poke-in connector disclosed in Patent Document 3, the surface mount soldering portion 125 of the contact 120 extends forward along an axial direction of the contact 120 from the front end of the large-diameter portion 122. Further, the surface mount soldering portion 126 extends backward along an axial direction of the contact 120 from the rear end of the small-diameter portion 121. Therefore, the dimensions of the contact 120 are long in the axial direction, which results in undesirable enlargement of the contact 120. This also gives rise to enlargement of the connector, and consequently also leads to degradation of, so-called, light distribution characteristics.

There can occasionally be situations in which the axial length of the contact 120 is too long and precludes mounting of the contact 120 on a small-sized substrate. Furthermore, a large surface mounting area of the contact 120 necessitates a lengthened distance (creepage distance) from a heat radiation plate (heat sink) disposed on a back side of the substrate to the substrate on which LED module is mounted and to which the surface mount soldering portions 125, 126 are soldered, or to the conductive pad formed on the substrate as the LED package. Thus, there has been a need to make the size of the substrate itself larger. However such enlargement, would not be appropriate since making the size of the substrate larger runs counter to a customer's demand for downsizing of the substrate. Further, in a case in which the contact 120 and the heat radiation plate are disposed on the back side of the substrate, the large mounting area of the contact 120 introduces a problem that a region of the heat radiation plate gets smaller as much, causing degradation of heat radiation characteristics. Accordingly, the present invention is made in view of the aforementioned problems and its objective is to provide a surface mount contact which can be assembled efficiently, provides improved light distribution characteristics and heat radiation characteristics, and is capable of prolonging the creepage distance from the heat radiation plate. The invention also provides a connector incorporating the contact.

To solve the problem described above, there is provided a surface mount contact according to any one of the appended claims 1 - 4.

There is further provided a connector according to the appended claim 5 that comprises the surface mount contact according to any one of the appended claims 1 to 4, and a housing in which the surface mount contact is accommodated. The connector according to the appended claim 6 is characterized in that the housing comprises an opening for inserting an electrical wire, and a stopper for stopping insertion of an end of a covering portion of the electrical wire.

According to the surface mount contact of the invention and the connector using the contact, since the lance is provided in the intermediate portion of the cylindrical portion along the axial direction, which bites into the core wire of the electrical wire inserted into the cylindrical portion for connecting to the electrical wire and stopping removal of the electrical wire, merely inserting the core wire of the electrical wire into the cylindrical portion allows connection to the electrical wire and prevents removal of the electrical wire. This provides good workability of wire connection and excellent assembly working efficiency.

According to the surface mount contact of the invention and the connector using the contact, having been configured to have the cylindrical portion formed in the cylindrical shape, into which only the core wire of the electrical wire is inserted, it is devoid of the large-diameter portion to guide the end of the covering portion of the electrical wire and the shoulder acting as a stopper to stop insertion of the end of the covering portion of the electrical wire. For this reason, downsizing of the contact and the connector in which the contact is accommodated may be achieved. This provides an LED light with excellent light distribution characteristics.

According to the surface mount contact according to the invention and the connector using the contact, since the pair of the surface mount soldering portions to be solder connected to the substrate project from the cylindrical portion, and each of the pair of the surface mount soldering portions extends in a direction orthogonal to the axial direction and from the end of the cylindrical portion along the axial direction, the arrangement shortens the length of the contact along the axial direction, thereby allowing downsizing of the contact along the axial direction. On that account, downsizing of the connector in which the contact is accommodated may also be achieved, thereby providing the connector with excellent, so-called light distribution characteristics.

Also, due to the short length of the contact in the axial direction, only a small mounting area is required for mounting, the contact. This enables mounting of the contact and the connector even on very small substrates. The small mounting area of the contact and the connector allows extension of the creepage distance from the heat radiation plate. Furthermore, in arrangements in which both the connector and the heat radiation plate are disposed on the back side of the substrate, owing to the small mounting area of the contact and the connector, the region occupied by the heat radiation plate can be small. This leads to the heat radiation plate having excellent heat radiation characteristics.

The invention will now be described by way of example only with reference to the accompanying drawings in which:
FIG. 1 is a sectional view of an embodiment of the connector according to the present invention, in which the electrical wire is also shown;
FIG. 2 shows an embodiment of the surface mount contact according to the present invention used in the connector shown in FIG. 1, in which FIG. 2A is a perspective view seen obliquely from above and from the rear side, and FIG. 2B is a perspective view seen obliquely from below and from the rear side;
FIG. 3 shows the housing used for the connector shown in FIG. 1, in which FIG. 3A is a perspective view seen obliquely from above and from the rear side, and FIG. 3B is a perspective view seen obliquely from below and from the rear side;
FIG. 4 is a perspective view showing an arrangement in which the connector shown in FIG. 1 is not yet mounted on a surface side of the substrate, on which the LED module is mounted, and the heat sink (heat radiation plate) is attached closely to an opposite back side of the substrate;
FIG. 5 is a perspective view showing an arrangement in which the connector shown in FIG. 1 is not yet mounted on a back side of the substrate, on the opposite side of which the LED module is mounted, and the heat sink is attached closely to the back side of the substrate;
FIG. 6 is a perspective view showing an arrangement in which the connector shown in FIG. 1 is attached to a surface side of the substrate including the LED package, and a heat sink is attached to the opposite side of the substrate to that including the LED package;
FIG. 7 is a perspective view showing an arrangement in which the connector shown in FIG. 1 is attached to the back side of the substrate including the LED package, and the heat sink is shown spaced apart from the back side of the substrate including the LED package; and
FIG. 8 shows the conventional low-profile surface mount poke-in connector, in which FIG. 8A is a perspective view of the housing, FIG. 8B is a perspective view of the contact, and FIG. 8C is a sectional view of the contact.

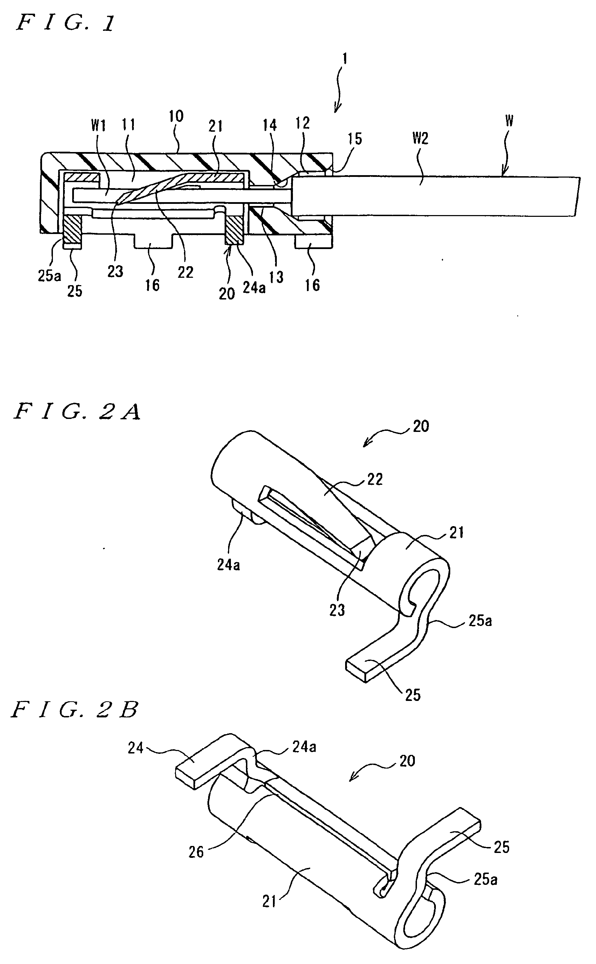

Hereinafter, a description is provided of an embodiment of the present invention with reference to the accompanying drawings. A connector 1 shown in FIG. 1 is attached. The connector 1 is mounted:
(i) to a surface of a substrate on which an LED module is mounted as shown in FIG. 4;
(ii) to a back side surface of the substrate on which the LED module is mounted as shown in FIG. 5;
(iii) to a surface of the substrate made up of or including, the LED package as shown in FIG. 6; and
(iv) to a back side surface of the substrate made up of or including the LED package as shown in FIG. 7. The connector is mounted for energizing LED chip 31 (see FIG. 4) and on LED chip 61(see FIG. 6).

The connector 1 comprises a housing 10, and a surface mount contact (hereafter simply referred to as a contact) 20 accommodated in or protruding from the housing 10. In FIG. 1, a lance 22 is depicted. As shown in FIG 1 the lance 22 is not in a bent or deflected state by an electrical wire W, but in an initial state. The contact 20 is, so-called, a poke-in contact and has a cylindrical portion 21 formed in a cylindrical shape, into which only a core wire W1 of the electrical wire W can be inserted. The connector 1 is shown in FIG. 1, FIG. 2A, and FIG. 2B. The contact 20 can be formed by stamping and forming a metal plate. The cylindrical portion 21 is formed by cylindrically bending the metal plate so as to join plate edges together at a seam 26, as shown in FIG. 2B. The seam 26 is positioned at the bottom side of the cylindrical portion 26.

In an axially intermediate portion of the cylindrical portion 21, the lance 22 is provided as shown in FIG. 1 and FIG. 2A. The lance 22 extends diagonally into the cylindrical portion 21 from an upper portion or portion opposing to the seam 26 of the cylindrical portion 21. At a tip of the lance 22, a sharp edge 23 is formed, which bites into the core wire W1 of the electrical wire W inserted into the cylindrical portion 21 for connecting to the electrical wire W, and stopping removal of the electrical wire.

At each axial end of the cylindrical portion 21 a surface mount soldering portion 24, 25 is provided. A pair of surface mount soldering portions 24, 25 are provided. These surface mount soldering portions 24, 25 may be solder connected, for example, to conductive pads 41 formed on a surface of a substrate 40 as shown in FIG. 4, or to conductive pads 41 formed on the back side surface of the substrate 40 as shown in FIG. 5. Further, the surface mount soldering portions 24, 25 may be solder connected, for example, to conductive pads 63 formed on a surface of a substrate 62 made up of or including an LED package 60 as shown in FIG. 6, or to conductive pads 63 formed on the back side surface of the substrate 62 made up of or including the LED package 60 as shown in FIG. 7.

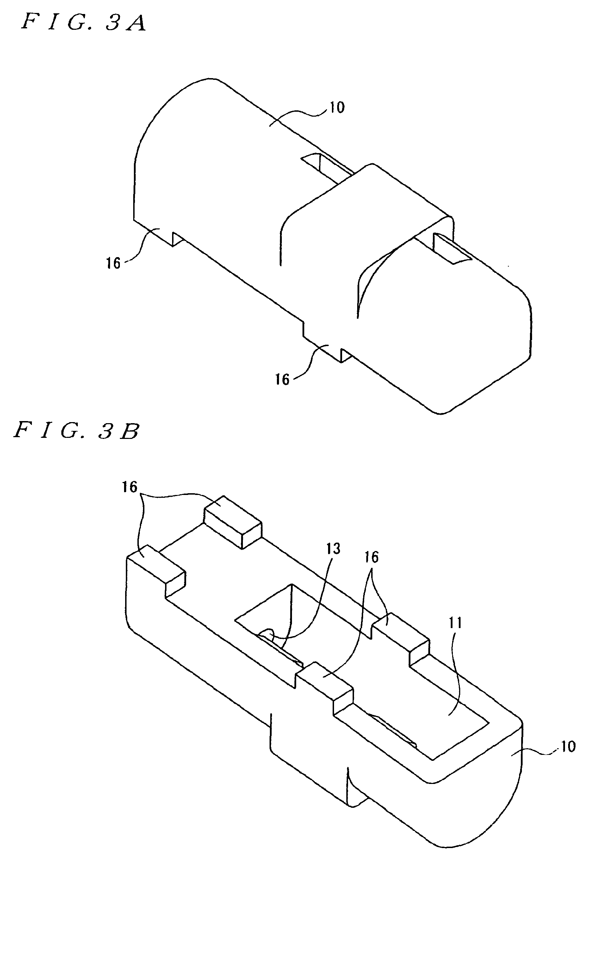

The surface mount soldering portion 24 provided at the front end in the axial direction (the right end shown in FIG. 1 and the left end shown in FIG. 2A and FIG. 2B) of the cylindrical portion 21 extends in a direction orthogonal to the axial direction via a junction 24a downwardly extending from the vicinity of the seam 26 positioned on the bottom side of the front end. Moreover, the surface mount soldering portion 25 provided at the rear end in the axial direction of the cylindrical portion 21 extends in a direction orthogonal to the axial direction via a junction 25a downwardly extending from the vicinity of the seam 26 positioned on the bottom side of the rear end. These surface mount soldering portions 24, 25 extend in an alternating, opposed or mutually opposite directions, as best shown in FIG. 2B. Furthermore, the housing 10 has therein a contact receiving recess 11, as shown in FIG. 1 and FIG. 3B. The housing 10 is formed by molding insulting resin. The contact receiving recess 11 is open to the bottom side of the housing 10 to receive the contact 20 through the opening, as shown in FIG. 1 and FIG. 3B.

On the front side (the right side shown in FIG. 1, and the left side shown in FIG. 3A and FIG. 3B) of the housing 10, an opening 12 into which the electrical wire W is inserted is formed. The opening 12 is formed so as to open at the front side of the housing 10, which is in communication with an insertion hole 13 via a stopper 14 formed by an inclined plane. At the forefront of the opening 12, an inclined plane or sloping surface 15 is formed, which facilitates insertion of the electrical wire W. The stopper 14 is formed by the inclined plane so as to lead into the opening 12. The opening 12 has a relatively larger diameter and the insertion hole 13 has a relatively smaller diameter. The stopper 14 functions to stop insertion of the end of the covering portion W2 of the electrical wire W, as shown in FIG. 1. Further, the insertion hole 13 is also formed in the housing 10 so as to communicate with the opening 12 and with the contact receiving recess 11. The diameter of the insertion hole 13 is one which permits only insertion of the core wire W1 of the electrical wire W.

On the bottom of the housing 10, a plurality of mounting portions or standoffs, 16 are provided which project from the bottom, as shown in FIG. 1, FIG. 3A, and FIG, 3B. A projection height of each mounting portion 16 is selected such that when the contact 20 is received in the housing 10, as shown in FIG. 1, an undersurface of each of the surface mount soldering portions 24, 25 of the contact 20 projects further from the bottom of the housing 10 than the undersurface of each mounting portion 16 (the undersurface is illustrated only for the surface mount soldering portion 25, in view of cross-sectional view shown in FIG 1). This feature ensures secure soldering of the surface mount soldering portions 24, 25.

In FIG. 4, a perspective view showing an arrangement in which the connector 1 shown in FIG. 1 is not yet mounted on the surface of the substrate 40, on which the LED module 30 is mounted. Here, the LED module 30 is one in which the LED chip 31 is enclosed by resin 32 such as silicone resin etc, and a plurality of terminals 33 extended from the LED module 30 and are connected to the surface of the substrate 40. The substrate 40 is made of a disc-shaped ceramic substrate, and the LED module 30 is mounted on the center of the surface. Around the LED module 30 of the substrate 40, two pairs of conductive pads 41 are provided. One pair out of the two pairs of the conductive pads 41 is connected to an anode side of the LED chip 31, whereas the other pair is connected to a cathode side of the LED chip 31. On the back side surface of the substrate 40, a disk-shaped heat sink (heat radiation plate) 50 is attached closely to or in intimate contact with the substrate 40.

An explanation will be provided of a technique of mounting the connector 1 on the surface of the substrate 40. On the occasion of assembling the connector 1, the contact 20 is first received in the contact receiving recess 11 of the housing 10 so that the pair of the surface mount soldering portions 24, 25 project from the bottom of the housing 10 as shown in FIG. 1. The surface mount soldering portions 24, 25 of the connector 1 are solder connected to the pair of the conductive pads 41 on the surface of the substrate 40. Moreover, the surface mount soldering portions 24, 25 of the other connector 1 are solder connected to the other pair of the conductive pads 41 on the surface of the substrate 40. Thereby, the connectors 1 are mounted on the surface of the substrate 40 (only one connector is show in FIG. 4

Next, the electrical wire W with the core wire W1 projecting from the covering portion W2 is inserted into the connector 1 through the opening 12 until the end of the covering portion W2 abuts against the stopper 14. Then, the core wire W1 of the electrical wire W is inserted into the cylindrical portion 21 of the contact 20 within the contact receiving recess 11 through the insertion hole 13. The electrical wire W is then pulled out slightly. By doing so, the sharp edge 23 formed at the tip of the lance 22 bites into the core wire W1 of the electrical wire W for connecting to the electrical wire W, and stopping removal of the electrical wire. This enables a supply of electricity from a power supply connected to the electrical wire W to be supplied to the LED chip 31.

Thus, according to the contact 20 and the connector 1 using the contact of the present embodiment, the lance 22 is provided in the intermediate portion of the cylindrical portion 21 along the axial direction, which bites into the core wire W1 of the electrical wire W inserted into the cylindrical portion 21 for connecting to the electrical wire W, and stopping removal of the electrical wire. Thereby, merely inserting the core wire W1 of the electrical wire W into the cylindrical portion 21 allows connection to the electrical wire W and prevents removal thereof. This leads to improved workability of wire connection and excellent assembly working efficiency.

In the contact 20 and the connector 1 including the contact of the present invention, the cylindrical portion 21 formed in a cylindrical shape is provided, into which only the core wire W1 of the electrical wire W is inserted. Thus, the contact 20 is devoid of a large-diameter portion for guiding the end of the covering portion W2 of the electrical wire W and is devoid of a shoulder acting as a stopper to stop insertion of the end of the covering portion of the electrical wire. Hence, downsizing of the contact 20 and the connector 1 in which the contact 20 is received may be achieved. This provides the LED light excellent, so-called, in light distribution characteristics.

Moreover, in to the contact 20 and the connector 1 using the contact of the present invention, the surface mount soldering portions 24, 25 solder connected to the substrate 40 are provided on the both ends of the cylindrical portion 21 along the axial direction, and each of the pair of the surface mount soldering portions 24, 25 extends in a direction orthogonal to the axial direction and from the end of the cylindrical portion 21. Thus, shortening of the axial length of the contact 20 and downsizing of the contact 20 may be achieved. This also enables downsizing of the connector 1, in which the contact 20 is received, and provides the contact 20 with excellent, so-called, in light distribution characteristics.

Due to the short length of the contact 20 in the axial direction, a small mounting area of the contact 20 may be achieved, thereby enabling the mounting of the contact 20 and the connector 1 on an even smaller substrate 40. The small mounting area of the contact 20 allows prolongation or extension of the creepage distance from the heat sink (heat radiation plate) 50. Here, "the creepage distance" comprises a distance L which is the sum of a distance L₂ from a surface of the heat sink 50 to an upper surface of the substrate 40, corresponding to the thickness of the substrate 40 in FIG. 4, and a liner distance L₁ from an edge of the upper surface of the substrate 40 to the conductive pad 41. "The creepage distance" needs to have a predetermined length stipulated under the Electrical Appliance and Material Safety Law.

In the contact 20 according to the present invention, the pair of the surface mount soldering portions 24, 25 extend in an alternating or in opposite directions. When solder connecting, this stabilizes a posture of the contact 20 when the pair of the surface mount soldering portions 24, 25 are placed on the conductive pad 41. This precludes the possibility of the contact 20 falling over during soldering. Additionally, one of the surface mount soldering parts 24, 25 is positioned further from the heat sink 50, thus increasing still further the creepage distance.

In the connector according to the present invention, the opening 12 is formed in the housing 10, into which the electrical wire W is inserted, and the stopper 14 is also provided, which stops insertion of the end of the covering portion W2 of the electrical wire W. This eliminates the need for the contact 20 to provide a structure allowing insertion of the covering portion W2 of the electrical wire W and a structure attaining the stopping function of the covering portion W2, thereby miniaturizing the contact 20. Consequently downsizing of the contact 20 is possible.

An explanation will be provided, referring to FIG. 5, to an arrangement in which the connector 1 shown in FIG. 1 is attached to the back side surface of a substrate 40, on the front surface side of which an LED module 30 is mounted. In FIG. 5, on the back side surface of the substrate 40, the heat sink 50 is attached closely or in intimate contact with the substrate 40. Two cutouts 51, larger than a region in which the connector 1 is mounted are formed on the back side surface of the substrate 40. On the back side surface of the substrate 40, two pairs of the conductive pads 41 (only one pair is shown) are provided in a region in which the connectors 1 are mounted. Upon mounting the connector 1, the surface mount soldering portions 24, 25 of the connector 1 are solder connected to the pair of the conductive pads 41 on the back side surface of the substrate 40. Further, the surface mount soldering portions 24, 25 of the other connector 1 are solder connected to the other pair of the conductive pads 41 on the back side surface of the substrate 40.

As with the arrangement shown in FIG. 1, the exposed or bared core wire W1 of the electrical wire W is inserted into the connector 1 through the opening 12 of each connector 1 until the end of the covering portion W2 abuts against the stopper 14, and then the electrical wire W is slightly pulled out. This results in, the sharp edge 23 formed at the tip of the lance 22 biting into the core wire W1 of the electrical wire W for connecting to the electrical wire W, and stopping removal of the electrical wire. Thus electricity from a power supply connected to the electrical wire W is supplied to the LED chip 31.

In this manner, when the connector 1 shown in FIG. 1 is attached to the back side surface of the substrate 40, that is the side on which the heat sink 50 is disposed, only a small region is required, the size of the cutout 51 in the heat sink 50, due to the short length of the contact 20 in the axial direction and the small mounting area of the contact 20 and the connector 1. Thus, the connector exhibits excellent in heat discharge characteristics. The small mounting area of the contact 20 and the connector 1 obviates the need for increasing the size of the cutout 51 which would lengthen the creepage distance from the heat sink 50. In this connection, it should be noted that even when the connector shown in FIG. 1 is attached to the back side surface of the substrate 40, that is the side on which the heat sink 50 is disposed, the same advantages occur as when the connector 1 is attached to the surface of the substrate 40, on the surface of which the LED module 30 is mounted.

An explanation will be made, referring to FIG. 6, to an arrangement in which the connector shown in FIG. 1 is attached to the surface of the substrate 62 made up of or including the LED package 60. The LED package 60 shown in FIG. 6 is one in which the LED chip 61 is enclosed by the substrate 62. On the surface of the substrate 62, two pairs of the conductive pads 63 are provided. Upon mounting the connector 1, the surface mount soldering portions 24, 25 of the connector 1 are solder connected to the pair of the conductive pads 63 on the surface of the substrate 62. Further, the surface mount soldering portions 24, 25 of the other connector 1 are solder connected to the other pair of the conductive pads 63 on the surface of the substrate 62.

Subsequently, as with the case shown in FIG. 1, a bared core wire W1 of the electrical wire W is inserted into each connector 1 through the opening 12 of connector 1 until the end of the covering portion W2 abuts against the stopper 14, and then the electrical wire W is slightly pulled out. Thereby, the sharp edge 23 formed at the tip of the lance 22 bites into the core wire W1 of the electrical wire W for connecting to the electrical wire, and stopping removal of the electrical wire. This enables electricity, from the power supply connected to the electrical wire W, to be supplied to the LED chip 61. In this way, even when the connector shown in FIG. 1 is attached to the surface of the substrate 62 made up of the LED module 60, the same advantages are achieved as for the arrangement in which the connector 1 shown in FIG. 1 is attached to the surface of the substrate 40, on the surface of which the LED module 30 is mounted.

Finally, an explanation will be provided, referring to FIG. 7, to an arrangement in which the connector 1 shown in FIG, 1 is attached to the back side surface of a substrate 62 made up of the LED package 60. In FIG. 7, although the heat sink 50 is depicted separated from the substrate 62, the heat sink 50 is actually attached closely or in intimate contact with the back side surface of the substrate 62. In the heat sink 50, two cutouts 51, larger than a region in which the connector 1 is mounted are formed on the back side surface of the substrate 62. Further, on the back side surface of the substrate 60, two pairs of the conductive pads 63 (only one pair is shown) are provided in the region in which the connector 1 is mounted.

Upon mounting the connector 1, the surface mount soldering portions 24, 25 of the connector 1 are solder connected to the pair of the conductive pads 63 on the back side surface of the substrate 62. Further, the surface mount soldering portions 24, 25 of the other connector 1 are solder connected to the other pair of the conductive pads 63 on the back side surface of the substrate 62. After that, as with the arrangement shown in FIG. 1, the bared core wire W1 of the electrical wire W is inserted into the connector 1 through the opening 12 of each connector 1 until the end of the covering portion W2 abuts against the stopper 14, and then the electrical wire W is slightly pulled out. Thereby, the sharp edge 23 formed on the tip of the lance 22 bites into the core wire W1 of the electrical wire W for connecting to the electrical wire W, and stopping removal of the electrical wire W. This enables electricity from the power supply connected to the electrical wire W to be supplied to the LED chip 61.

In this way, even when the connector 1 shown in FIG. 1 is attached to the back side surface of the substrate 62 made up of the LED package 60, the same advantages may be achieved as the arrangement in which the connector 1 shown in FIG. 1 is attached to the back side surface of the substrate 40. It should be appreciated that while the description has been made with reference to the depicted embodiments of the present invention, the present invention may pursue various modifications and add improvements falling within the scope of the claims, without being limited by the above disclosure.

For example, the substrate on which the contact 1 is mounted is not restricted to the substrate 40 on which the LED module 30 is mounted and the substrate made up of the LED package 60. Alternatively, a general circuit board may of course be used. Moreover, the pair of the surface mount soldering portions 24, 25 may not necessarily extend in the alternating direction. The pair of the surface mount soldering portions may, for example, project from respective ends of the cylindrical portion 21 along the axial direction so as to mutually extend in opposite directions. With such an arrangement, the peeling strength needed to tear the contact off from the substrate may be increased.

Further, the pair of the surface mount soldering portions may, for example, project from only on the one end of the cylindrical portion 21 along the axial direction so as to mutually extend in opposite directions. With such an arrangement, the creepage distance may be extended, and mounting of another part or connector be made more flexible. Furthermore, two pairs of the surface mount soldering portions may project from the intermediate region apart from both ends of the cylindrical portion 21 along the axial direction so as to mutually extend in opposite directions. With such an arrangement, a press fitting portion of the housing may be provided at least on one end of the cylindrical portion 21 along the axial direction, facilitating assembly of the contact with the housing.

### Reference Signs List

1: connector
10: housing
12: opening
14: stopper
20: surface mount contact
21: cylindrical portion
22: lance
40,62: substrate
24, 25: surface mount soldering portion
W: electrical wire
W1: core wire
W2: covering portion

## Claims

1. A surface mount contact (20) comprising a cylindrical portion (21) formed in a cylindrical shape for inserting a core wire (W1) of an electrical wire (W) into the cylindrical portion (21), a lance (22) being provided in an intermediate portion of the cylindrical portion (21) along an axial direction thereof, the lance for biting into the core wire (W1) of the electrical wire (W) when inserted into the cylindrical portion (21) for connecting to the electrical wire (W) and stopping removal of the electrical wire (W), and a pair of surface mount soldering portions (24,25) configured to be solder connected to a substrate (40) and projecting from the cylindrical portion (21), wherein each of the pair of the surface mount soldering portions (24,25) extends in a direction orthogonal to the axial direction, **characterized in that** each of the pair of the surface mount soldering portions (24,25) extends from an end of the cylindrical portion (21) along the axial direction, **in that** the cylindrical portion is for inserting only the core wire (W1) of the electrical wire (W), and **in that** the pair of the surface mount soldering portions (24,25) extend in alternating or opposite directions to one another.

2. The surface mount contact (20) according to claim 1, wherein the pair of the surface mount soldering portions (24, 25) project from respective ends of the cylindrical portion along the axial direction.

3. The surface mount contact (20) according to claim 1, wherein the pair of the surface mount soldering portions project from only one end of the cylindrical portion (21) along the axial direction.

4. The surface mount contact according to claim 1, wherein two pairs of the surface mount soldering portions project from a central region apart from both ends of the cylindrical portion (21) along the axial direction.

5. A connector comprising the surface mount contact (20) according to any one of claims 1 to 4, and a housing (10) in which the surface mount contact (20) is accommodated.

6. The connector according to claim 5, wherein the housing (10) comprises an opening (12) for inserting an electrical wire (W), and a stopper (14) for stopping insertion of an end of a covering portion (W2) of the electrical wire (W).

## Patentansprüche

1. Oberflächenmontagekontakt (20), umfassend: einen in einer zylinderförmigen Form ausgebildeten zylinderförmigen Abschnitt (21) zum Einstecken eines Kerndrahtes (W1) einer elektrischen Leitung (W) in den zylinderförmigen Abschnitt (21), wobei in einem Mittelabschnitt des zylinderförmigen Abschnitts (21) entlang einer Achsenrichtung desselben eine Lanze (22) vorgesehen ist, wobei die Lanze zum Eingreifen in den Kerndraht (W1) der elektrischen Leitung (W), wenn sie in den zylinderförmigen Abschnitt (21) eingesteckt wird, zum Verbinden mit der elektrischen Leitung (W) und Aufhalten des Herausnehmens der elektrischen Leitung (W) dient, und ein Paar von Oberflächenmontagelötabschnitten (24, 25), die dafür konfiguriert sind, mit einem Substrat (40) lötverbunden zu werden, und von dem zylinderförmigen Abschnitt (21) hervorstehen, worin sich jedes Paar der Oberflächenmontagelötabschnitte (24, 25) in einer Richtung orthogonal zur Achsenrichtung erstreckt, **dadurch gekennzeichnet, dass** sich jeder des Paars der Oberflächenmontagelötabschnitte (24, 25) von einem Ende des zylinderförmigen Abschnitts (21) entlang der Achsenrichtung erstreckt, dass der zylinderförmige Abschnitt (21) nur zum Einstecken des Kerndrahtes (W1) der elektrischen Leitung (W) dient, und dass sich das Paar der Oberflächenmontagelötabschnitte (24, 25) in abwechselnden oder entgegengesetzten Richtungen zueinander erstreckt.

2. Oberflächenmontagekontakt (20) nach Anspruch 1, worin das Paar der Oberflächenmontagelötabschnitte (24, 25) von jeweiligen Enden des zylinderförmigen Abschnitts entlang der Achsenrichtung hervorsteht.

3. Oberflächenmontagekontakt (20) nach Anspruch 1, worin das Paar der Oberflächenmontagelötabschnitte nur von einem Ende des zylinderförmigen Abschnitts (21) entlang der Achsenrichtung hervorsteht.

4. Oberflächenmontagekontakt nach Anspruch 1, worin zwei Paare der Oberflächenmontagelötabschnitte von einem mittleren Bereich hervorstehen, der von beiden Enden des zylinderförmigen Abschnitts (21) entlang der Achsenrichtung getrennt ist.

5. Verbinder, umfassend den Oberflächenmontagekontakt (20) nach einem der Ansprüche 1 bis 4 und ein Gehäuse (10), in dem der Oberflächenmontagekontakt (20) untergebracht ist.

6. Verbinder nach Anspruch 5, worin das Gehäuse (10) eine Öffnung (12) zum Einstecken einer elektrischen Leitung (W) und einen Anschlag (14) zum Aufhalten des Einsteckens eines Endes eines Ummantelungsabschnitts (W2) der elektrischen Leitung (W) umfasst.

## Revendications

1. Contact à montage en surface (20), comprenant une partie cylindrique (21) formée en une forme cylindrique, en vue de l'insertion d'un fil central (W1) d'un fil électrique (W) dans la partie cylindrique (21), une lance (22) étant agencée dans une partie intermédiaire de la partie cylindrique (21), le long d'une direction axiale de celle-ci, la lance étant destinée à s'engager dans le fil central (W1) du fil électrique (W) lors de son insertion dans la partie cylindrique (21), en vue de la connexion au fil électrique (W) et de l'arrêt du retrait du fil électrique (W), et une paire de parties de soudage à montage en surface (24, 25) configurées de sorte à être connectées par soudage à un substrat (40), et débordant de la partie cylindrique (21), dans lequel chacune de la paire des parties de soudage à montage en surface (24, 25) s'étend dans une direction orthogonale à la direction axiale, **caractérisé en ce que** chacune de la paire des parties de soudage à montage en surface (24, 25) s'étend à partir d'une extrémité de la partie cylindrique (21) le long de la direction axiale, **en ce que** la partie cylindrique sert uniquement à l'insertion du fil central (W1) du fil électrique (W), et **en ce que** la paire des parties de soudage à montage en surface (24, 25) s'étend dans des directions alternées ou opposées l'une vers l'autre.

2. Contact à montage en surface (20) selon la revendication 1, dans lequel la paire des parties de soudage à montage en surface (24, 25) débordent des extrémités respectives de la partie cylindrique, le long de la direction axiale.

3. Contact à montage en surface (20) selon la revendication 1, dans lequel la paire des parties de soudage à montage en surface débordent d'une seule extrémité de la partie cylindrique (21), le long de la direction axiale.

4. Contact à montage en surface selon la revendication 1, dans lequel deux paires de parties de soudage à montage en surface débordent d'une région centrale, à l'exception des deux extrémités de la partie centrale (21), le long de la direction axiale.

5. Connecteur comprenant le contact à montage en surface (20) selon l'une quelconque des revendications 1 à 4, et un boîtier (10) dans lequel est reçu le contact à montage en surface (20).

6. Connecteur selon la revendication 5, dans lequel le boîtier (10) comprend une ouverture (12) en vue de l'insertion d'un fil électrique (W), et une butée (14) pour arrêter l'insertion d'une extrémité d'une partie de couverture (W2) du fil électrique (W).
